# EUROPEAN PATENT SPECIFICATION

(11) **EP 2 805 065 B1**
(45) Date of publication and mention of the grant of the patent: **30.10.2019**
(21) Application number: 12806518.2
(22) Date of filing: 20.09.2012
(51) Int. Cl.: F16B 1/00, G12B 1/00, H01L 41/12

(54) **METHOD OF DETERMINING THE COMPATIBILITY OF TWO COMPONENTS**
VERFAHREN ZUR BESTIMMUNG DER KOMPATIBILITÄT VON ZWEI KOMPONENTEN
PROCÉDÉ DE DÉTERMINATION DE LA COMPATIBILITÉ DE DEUX ÉLÉMENTS

(30) Priority: 21.09.2011 FI 20115925
(43) Date of publication of application: 26.11.2014
(73) Proprietor: ETO MAGNETIC GmbH, 78333 Stockach (DE)
(72) Inventor: KORPIOLA, Kari, FI-00390 Helsinki (FI); NISKANEN, Antti, FI-00390 Helsinki (FI); PERENTO, Jukka, FI-00390 Helsinki (FI)
(74) Representative: Patentanwälte Behrmann Wagner PartG mbB
(86) International application number: PCT/FI2012/050908
(87) International publication number: WO 2013/041772

(56) References cited:
- DE-A1-102009 053 808
- US-A- 3 816 902
- US-A1- 2005 036 828

## Description

The present invention relates to a method, according to Claim 1, for determining the mutual compatibility (i.e. affinity) of components to be connected to each other.

According to such a method, at least one of the components is equipped with a security marking.

In Europe, ever year counterfeit products cause losses to the owners of the intangible rights in original products. Fake technical products are also potentially dangerous to users. Connected to a functioning device, for example, as a component or an accessory of the device, they can lead to operating disturbances and accidents. A counterfeit component in, or an accessory to an electronic device can abnormally overheat the device; a counterfeit electronic-device component can also cause short-circuits. These can lead, in turn, to explosions or fires. A counterfeit technical device or its fake component or accessory can cause serious injury to the user, such as bums, or even blindness.

To distinguish genuine products from counterfeit products, the sales packages and cases of products are typically equipped with security markings. These are based on, for example, optical detection (such as using holograms) or on magnetic/electrical detection (RFID elements, conductive areas). Forging such security markings is difficult and expensive, which significantly increases the price of a fake.

Security markings are attached not only to sales packages, but also to the actual product, for example, to the CD-ROM disc of a computer program.

US 3 816 902 A discloses a method of engaging elements in cooperation physical relationship on the basis of a first and a second component whereas at least one of which is able to change its shape due to the effect of a magnetic field. Further the documents US 2005/036828 A1 and DE 10 2009 053808 A1 are known.

Although traditional security markings assist wholesale traders in removing fakes from the distribution chain and correspondingly the consumer in distinguishing a counterfeit product from a genuine one when purchasing it, they do not, however, entirely remove the danger that, for example, a counterfeited spare part or accessory for a technical device will be used despite detection.

The present invention is intended to create a new type of solution to ensure the functionality of a device totality, which consists of two or more components, at least one of which components of the device is typically replaceable, and the full compatibility of which with the other components of the device totality is essential for the safe use of the
device totality.

The invention is based on the idea that, in order to determine the mutual compatibility of at least two components connected to each other, at least the first component is equipped with a three-dimensional piece, which is able to change its shape due to the effect of heat,
or magnetic field, electromagnetic radiation, or an external force (e.g., a mechanical force) - or a combination of these. Such a three-dimensional piece comprises most suitably a metallic alloy, which is able to change shape, for example, in a lattice structure, through changes taking place due to external forces.

For its part, at least one other component, preferably to be connected to the above component, is equipped with an energy source, such as a control element, which is able to produce a magnetic field, heat, an electromagnetic effect, or a combination of these, or of some other force, such as a mechanical force.

When the first and second components are brought into the immediate vicinity of each other, and when the control element of the second component is used to direct to the metal-alloy piece of the first component magnetic field, heat, an electromagnetic effect/radiation, some other force, such as a mechanical force, or some
combination of these, the three-dimensional shape or magnetic properties of the security-marking piece change, when, if the change exceeds a predefined limit value, the compatibility of the components can be determined.

Considerable advantages are gained by means of the present invention. Thus, by using as a security-marking piece manufactured from a memory metal, the genuineness of a product being examined can be determined both optically and mechanically; which is not possible in the case of conventional optical security markings. The change in the mechanical shape of the security marking or the change in its magnetic properties can be further exploited to create an operation or function. It can be used, for example, to open a lock or connect a power circuit. The operation or function can be a precondition for the use of the product, which prevents the use of a counterfeit product in a selected application. Being an active security marking, it also differs from conventional security markings, which are typically passive.

In a particularly preferred embodiment, the movement of a memory metal can be exploited in a way that triggers the functional connection of the component equipped with the security marking to another component. An example is a case, in which the actual operation or function demands the replacement of a worn-out part with another (e.g., an ink cartridge in a printer), in which case the receiving station in the device is equipped with a lock or an openable circuit and the replacement component is equipped with a security marking consisting of a memory metal, which is able through its deformation to act as a key, which opens the lock of the reception station and/or switches on power in the circuit.

In the following, the invention is examined more closely with the aid of a detailed description.

As stated above, with the aid of the invention a method is created, by means of which is it possible to determine whether two components that can be connected to each other really do belong together. This determining of the 'mutual compatibility' of the components includes an examination of the e.g., mechanical, electrical, and/or functional compatibility
of the components. Alternatively - or preferably in addition to these properties - the compatibility of the origin of the components is examined, i.e. are they from the same manufacturer or supplier, or have the suppliers a mutual authorization relationship? This latter examination represents the determining of the genuineness of, for example, a spare part or accessory.

According to the invention, the first component is equipped with a three-dimensional security-marking piece, which is able to change its shape due to the effect of a magnetic field, heat, electromagnetic radiation, or a combination of these. The size of the piece is typically: length 0.01... 100 mm, thickness 0.01- 100 mm, and height 0.01 - 100 mm.

The second component, which can be connected to the first component, is equipped with an operating element, which is able to produce an energy effect in the form of a magnetic field, heat, or electromagnetic radiation, or other external force, or a combination of these. The first and second components are brought into the immediate
vicinity of each other, and, by means of the operating element of the second component, an energy effect is directed to the security-marking piece of the first component in order to change its three-dimensional shape.

In an alternative embodiment, a change is created in the magnetic properties of the security-marking piece, particularly a metallic-alloy piece (see details below), with the aid of an external force. Such an external force can be produced, for example, by means of screw threads, or even by pushing by hand.

The deformation described above is defined, and the components are determined to be compatible, if the change in the shape of the security-marking piece exceeds a predefined limit value. Particularly with memory metals (MSM materials), this deformation also causes a change in the magnitude and/or direction of the magnetic field, which can thus be exploited in determining and/or creating operations or functions, for example, with the aid of 'triggering'.

In the following, the security-marking piece is also referred to by the term 'metal-alloy piece', which is used especially to refer to a preferred embodiment, in which the security-marking piece is a memory-metal or similar metal-alloy piece. However, the explanation should not be understood a way that would restrict the features described below to
precisely this embodiment, even though it represents a very good solution.

It should also be stated about the above that the concept 'able to be connected to a first component' includes in general all cases, in which a first and a second component are connected to each other. The first component can also be able to be connected to a second component. This is the case, for example, in the solution referred to above, in which a replaceable ink. cartridge of a print is equipped with a security marking that permits the ink. cartridge to operate in the printer.

Particularly preferably the security-marking piece, such as a metal-alloy piece, is permanently attached to the first component. The term 'permanently attached' refers to, among other things, the fact that the security-marking piece cannot be separated from the first component, without a permanent trace of the security-marking piece remaining in the component.

According to a preferred embodiment, the second component is equipped with an energy source or an operating element, which produces a magnetic field, or electromagnetic radiation, or heat, or a combination of these. In one embodiment, the operating element is a permanent magnet or electromagnet, for example, a suitable coil,
which is able to produce magnetically a deformation in a metal-alloy piece (memory metal). In a second embodiment, the operating element is a thermal resistance, a Peltier element, a thermal radiator, or similar heating element, which is able to warm or heat a metal-alloy piece.

In order for the energy source of the second component to be able to create the desired effect, it must generally be brought sufficiently close to the metal-alloy piece. In one embodiment, it is brought into contact with the metal-alloy piece. In a second embodiment, the distance between the energy source and the metal-alloy piece is about 0.01- 100 mm,
most suitably 0.1 - 50 mm.

As a result of the energy produced in the metal-alloy piece, the shape of the piece changes, as a result of the changes taking place in its lattice structure. The magnitude of the change in a single dimension is generally in the order of a few percent; the change is, for example, about 0.01 - 20 %, most suitably 0.1 - 15 %, calculated from one dimension, for example
the length, of the piece.

In the case of metal alloys, such as memory metals, it is preferable to direct a magnetic field. which has a strength of about 0.0001 - 1 T, to the metal-alloy piece.

The temperature effect will generally be sufficient, if the temperature of the piece can be raised from the ambient temperature to the austenite temperature, or slightly above it.

In one embodiment, the change in the shape of the metal-alloy piece is determined mechanically, electrically, magnetically (e.g., using a Hall sensor), or by combining these techniques, for example, mechanically and electrically.

In order to determine the change in shape, the metal-alloy piece connected to the first component is arranged in such a way that, in the state in which its shape has been changed by the effect of a magnetic field, heat, an external (mechanical) force, or a combination of these, the metal-alloy piece creates an operation or function.

The second component can be, for example, a machine or device, which is equipped with a receiving station, into which the first component can be placed, in which case only a component that has been determined to be genuine will permit the basic operation of the machine or device.

In one embodiment, the components together form a device structure, which has a preselected operation or function, in which case the three-dimensional metal-alloy piece is arranged in such a way that, in the state in which its shape has been changed by the effect of magnetic field, heat, an external force, or a combination of these, the metal-alloy piece permits the said operation or
function.

In another embodiment relating to this embodiment, the metal-alloy piece triggers the operation or function, when it moves to a deformation state.

The change in the shape of the metal-alloy piece can also be detected by using a separate sensor. This can be, for example, mechanically or magnetically operated.

In one particularly preferred embodiment, the connection of the first and second component is possible only if the metal-alloy piece is in a deformation state.

The metal-alloy piece and the operating element form together the parts of a lock, so that the metal-alloy piece is able to open the lock. After the opening of the lock, the device is able to create the selected operation or operations.

In the invention, one component is a machine and the other is a replaceable part, such as a spare part or an accessory. In a preferred embodiment, the replaceable part of the machine is the aforementioned first component, which is equipped with a metal-alloy piece, or a corresponding security-marking piece.

The metal-alloy piece comprises most suitable a so-called memory metal. A memory metal (Shape Memory Alloy, SMA) is a metal alloy, which is able to change its crystalline structure when subject to the effect of an external force. In the case of an SMA, a temperature change generally takes martensite->austenite and back again. The change is reversible.

Most memory metals change their lattice structure between an austenitic and a martensitic state under the influence of changes in temperature. There is also a particular type of memory metal, which changes its shape due to the effect of a magnetic field. These memory metals are typically ferromagnetic (Ferromagnetic Shape Memory Alloy, FSMA). The particular advantage of these metals is that the deformations take place more rapidly and effectively from the effect of a magnetic field than through temperature changes.

According to one embodiment, the metal-alloy piece is manufactured from a magnetic memory metal, a magnetostrictive material, an SMA material, or an electroactive (artificial-muscle) polymer.

According to a second embodiment, the security-marking piece consists of single-crystal material, a multi-crystal material, a composite material, in which case, for example, the substance comprises granules (particles, single crystals, or groups of them) and a binder, or of a thin-film material.

In the invention, the metal alloy consists of an NiMnGa alloy, which possibly contains one or more additional metals, which are, for example, Co, Fe, Cu, In, or
Sn. Such a material will change its shape and crystalline structure due to the effect of a magnetic field.

In a second preferred embodiment, the metal alloy piece consists of Terfenol (TbDyFe), Galefenol (FeGa), or Nitinol (NiTi). Terfenol ja Galfenol are other examples of metal alloys that change shape due to the effect of a magnetic field - they are so-called magnetostrictive products, which same group also includes an iron-palladium alloy (FePd). For its part, Nitinol is an example of a material that changes due to the effect of heat.

The above description is mainly of ways, by means of which the dimensions of a security-marking piece can be affected magnetically or electrically, or by electromagnetic radiation, or by a combination of these. In a second solution of the invention, a phenomenon is exploited, in which a change in the shape of a piece, created by an external force, also
leads to a change in the magnetic, or generally the 'electromagnetic' properties of the piece. Thus, by means of an external force, it is possible to create a change of, for example, as much as 20 %, particularly about 0.01 - 15 % in at least one dimension of a piece, in which case the magnetic field of the piece will be made to rotate by as much as 90 degrees.

For example, the piece can be compressed or stretched. Such a force effect can be achieved by pushing or rotating the second component against the security-marking piece of the first component. If desired, a mechanical force can be directed to the piece, which alters it in a different way and to a different extent in different dimensions.

The change in electromagnetic field, for example a change in magnetic field, that then takes place in the piece, can be detected using a sensor, or as a rotational moment in the magnetic field running through the piece. If an external effect, electricity, heat, a magnetic field, radiation, or other external mechanical force, is directed to the piece, the change in magnetic properties will cause rotation in the magnetic elements along with the lattice axes.

In the second piece, a change in the direction of the magnetic field can be changed into a movement, which can be used to drive an operating device relating to the device totality, for example. it can be used to open and close a locking mechanism in the device.

Thus, based on the above, a metal-alloy piece manufactured from a memory metal can generally be used as a security marking suitable for determining a product's genuineness.

The present solution is suitable for use in, among others, the following applications: electronic products, such as mobile telephones and their parts and accessories, audio and video devices and their parts and accessories, computers and their parts and accessories, printers and their parts and accessories, domestic appliances and their parts and accessories, vehicles and their spare parts and accessories, lighting fittings and their parts and accessories, air-conditioning devices, ventilators, and fans and their parts and accessories, devices and means intended for health and sickness care as well as their parts and accessories, security devices, such as locks and keys, weapons and ammunition, as well as filtering devices and their parts and accessories.

In one embodiment, the key to a lock is equipped with a piece consisting of a memory metal (MSM), which activates the lock. If the lock does not detect the MSM piece, it refuses to open, no matter whether the key is otherwise correctly cut. This solution can be used to prevent the trivial copying of a key.

Particularly advantageously, a security marking, particularly a metal-alloy piece manufactured from a magnetic memory metal, can be used in an ink-jet cartridge, a colour cartridge, a gas bottle, a lock or key, a computer or mobile-telephone battery, computer or mobile-telephone charges, incandescent lamps, fluorescent lamps and other mercury-vapour lamps, LED lamps, neon and other discharge lamps, high-pressure sodium lamps, sulphur-plasma lamps, pharmaceutical-dosing devices, as well as in air filters.

## Claims

1. Method for determining the mutual compatibility of two components to be connected to each other, wherein
- the first component is equipped with a three-dimensional security-marking piece, which consists of a metal-alloy piece, which is able to change its shape or magnetic properties due to the effect of a magnetic field, heat, thermal radiation, mechanical force, or a combination of these,
- the second component is connected to the first component by means of an operating device, which is able to produce a magnetic field, heat, a thermal-radiation effect, a mechanical force, or a combination of these,
- the first and second components are brought into the immediate vicinity of each other,
- the operating device of the second component is used to direct to the metal-alloy piece of the first component a magnetic field, heat, a thermal-radiation effect, a mechanical force, or a combination of these, in order to change the three-dimensional shape or magnetic properties of the security-marking piece,
- the change in the shape or properties of the security-marking piece is determined, and
- the components are determined to be compatible, if the change in shape or magnetic properties exceeds a predefined limit value,
wherein the connection of the first and the second components to each other is possible only if the security-marking piece is in a deformation state, or, one component is a machine or device, and the other component is a replaceable part of the machine or device,
and wherein the metal alloy consists of an NiMnGa alloy, which possibly contains one or more additional metals, which are, for example, Co, Fe, Cu, In, or Sn.

2. Method according to Claim 1, in which the change in shape of the piece connected to the first component is determined mechanically, electrically, magnetically, or by a combination of these, particularly mechanically and electrically.

3. Method according to Claim 1 or 2, in which the security-marking piece connected to the first component is arranged in such a way that, in the state, in which its shape has been changed by the effect of voltage, an electric or magnetic field, heat, thermal radiation, or a combination of these, the piece creates an operation or function.

4. Method according to Claim 3, in which the security-marking piece triggers an operation or function, when it changes to a deformation state.

5. Method according to any of the above Claims, in which the change in the shape of the security-marking piece is detected by means of a sensor.

6. Method according to Claim 1, in which the security-marking piece and the operating element together form a lock, or are part of a power circuit, or are able to create its connection, so that the security-marking piece is able to open the lock or connect the power circuit, so that, after the opening, the device creates the selected operation or operations.

7. Method according to Claim 1, in which the components together form a device structure, which has a preselected operation or function, in which case the three-dimensional security-marking piece is arranged in such a way that, in a state, in which its shape has changed as a result of the effect of voltage, an electric or magnetic field, heat, thermal radiation, a mechanical force, or a combination of these, the security-marking piece permits the said operation or function.

8. Method according to any of the above Claims, in which
- the security-marking piece consists of a metal alloy and
- the metal-alloy piece is manufactured from a memory-metal (SMA) material that changes its shape due to the effect of changes in temperature, a magnetostrictive material, a magnetic memory-metal material, or an electroactive (artificial-muscle) polymer.

9. Method according to any of the above Claims, in which the security-marking piece consists of a single-crystal material, a multi -crystal material, or a composite material, in which case the substance, for example, comprises granules and a binder, or a thin-film material.

10. Method according to any of the above Claims, in which
- the first component is equipped with a three-dimensional metal-alloy piece, the electromagnetic properties of which change as a function of the dimensions of the piece,
- the mechanical effect is directed by the second component to the metal-alloy piece of the first component in order to change the dimensions of the metal-alloy piece, in order to modify its electromagnetic properties,
- the changed electromagnetic properties of the metal-alloy piece are determined, and
- the components are determined to be compatible, if the change in the electromagnetic properties exceeds a predefined limit value.

11. Method according to Claim 10, in which the magnetic properties of the piece, its electrical properties, or a combination of these are changed mechanically.

12. Method according to Claim 10 or 11, in which the piece is stretched or compressed together in at least one dimension.

13. Method according to any of Claims 10 -12, in which the dimensions of the piece are changed in at least one dimension by 0.01 - 20 %, particularly by about 0.1 - 15 %.

14. Method according to any of Claims 9 - 13, in which the change in the electromagnetic properties of the piece are determined by means of a sensor.

## Patentansprüche

1. Verfahren zum Bestimmen der gegenseitigen Kompatibilität von zwei miteinander zu verbindenden Elementen, wobei
- das erste Element mit einem dreidimensionalen Sicherheitsmarkierungsteil ausgestattet ist, welches aus einem Metalllegierungsteil besteht, welches seine Form oder magnetischen Eigenschaften aufgrund der Wirkung eines magnetischen Felds, von Wärme, von Wärmestrahlung, einer mechanischen Kraft oder einer Kombination aus diesen verändern kann,
- das zweite Element mit dem ersten Element mittels einer Wirkvorrichtung verbunden ist, welche ein magnetisches Feld, Wärme, einen Wärmestrahlungseffekt, eine mechanische Kraft oder eine Kombination aus diesen erzeugen kann,
- das erste und das zweite Element in die unmittelbare Nähe zueinander gebracht werden,
- die Wirkvorrichtung des zweiten Elements dazu verwendet wird, ein magnetisches Feld, Wärme, einen Wärmestrahlungseffekt, eine mechanische Kraft oder eine Kombination aus diesen auf das Metalllegierungsteil des ersten Elements zu richten, um die dreidimensionale Form oder die magnetischen Eigenschaften des Sicherheitsmarkierungsteils zu verändern,
- die Veränderung der Form oder der Eigenschaften des Sicherheitsmarkierungsteils bestimmt wird, und
- die Elemente als kompatibel bestimmt werden, wenn die Veränderung der Form oder der magnetischen Eigenschaften einen vordefinierten Grenzwert überschreiten,
wobei die Verbindung des ersten und des zweiten Elements miteinander nur möglich ist, wenn das Sicherheitsmarkierungsteil in einem Veränderungszustand ist, oder wenn ein Element eine Maschine oder eine Vorrichtung ist und das andere Element ein austauschbares Teil der Maschine oder der Vorrichtung ist,
und wobei die Metalllegierung aus einer NiMnGa-Legierung besteht, welche gegebenenfalls ein zusätzliches Metall oder mehrere zusätzliche Metalle, wie zum Beispiel Co, Fe, Cu, In, oder Sn, umfasst.

2. Verfahren nach Anspruch 1, wobei die Veränderung der Form des mit dem ersten Element verbundenen Teils mechanisch, elektrisch oder magnetisch oder durch eine Kombination aus diesen, insbesondere mechanisch und elektrisch, bestimmt wird.

3. Verfahren nach Anspruch 1 oder 2, wobei das mit dem ersten Element verbundene Sicherheitsmarkierungsteil derart angeordnet ist, dass das Teil in dem Zustand, in dem seine Form durch die Wirkung von Spannung, eines elektrischen Felds oder eines magnetischen Felds, von Wärme, von Wärmestrahlung oder einer Kombination aus diesen verändert ist, eine Wirkung oder eine Funktion auslöst.

4. Verfahren nach Anspruch 3, wobei das Sicherheitsmarkierungsteil eine Wirkung oder eine Funktion auslöst, wenn es in einen Verformungszustand wechselt.

5. Verfahren nach einem der vorangehenden Ansprüche, wobei die Veränderung der Form des Sicherheitsmarkierungsteils mittels eines Sensors festgestellt wird.

6. Verfahren nach Anspruch 1, wobei das Sicherheitsmarkierungsteil und das Wirkelement zusammen eine Sperre bilden oder Teil eines Stromkreises sind, oder dessen Verbindung herstellen können, so dass das Sicherheitsmarkierungsteil die Sperre entsperren oder den Stromkreis verbinden kann, so dass die Vorrichtung nach dem Entsperren die ausgewählte Wirkung oder ausgewählten Wirkungen auslöst.

7. Verfahren nach Anspruch 1, wobei die Elemente zusammen eine Vorrichtungsstruktur bilden, die eine vorausgewählte Wirkung oder Funktion aufweist, wobei das dreidimensionale Sicherheitsmarkierungsteil derart angeordnet ist, dass das Sicherheitsmarkierungsteil in einem Zustand, in dem sich seine Form als Folge der Wirkung von Spannung, eines elektrischen oder eines magnetischen Felds, von Wärme, von Wärmestrahlung, einer mechanischen Kraft oder einer Kombination aus diesen verändert hat, die Wirkung oder Funktion zulässt.

8. Verfahren nach einem der vorangehenden Ansprüche, wobei
- das Sicherheitsmarkierungsteil aus einer Metalllegierung besteht und
- das Metalllegierungsteil aus einem Formgedächtnismaterial (FGL), welches seine Form aufgrund der Wirkung von Temperaturänderungen verändert, einem magnetostriktiven Material, einem magnetischen Formgedächtnismaterial oder einem elektroaktiven Polymer (künstlichen Muskeln) hergestellt ist.

9. Verfahren nach einem der vorangehenden Ansprüche, wobei das Sicherheitsmarkierungsteil aus einem Einkristallmaterial, einem Polykristallmaterial oder einem Verbundmaterial, wobei die Substanz zum Beispiel Granulate und ein Bindemittel umfasst, oder einem Dünnschichtmaterial besteht.

10. Verfahren nach einem der vorangehenden Ansprüche, wobei
- das erste Element mit einem dreidimensionalen Metalllegierungsteil ausgestattet ist, dessen elektromagnetische Eigenschaften sich in Abhängigkeit von den Maßen des Teils verändern,
- die mechanische Wirkung durch das zweite Element auf das Metalllegierungsteil des ersten Elements gerichtet wird, um die Maße des Metalllegierungsteils zu verändern, um dessen elektromagnetische Eigenschaften zu ändern,
- die veränderten elektromagnetischen Eigenschaften des Metalllegierungsteils bestimmt werden, und
- die Elemente als kompatibel bestimmt werden, wenn die Veränderung der elektromagnetischen Eigenschafften einen vordefinierten Grenzwert überschreitet.

11. Verfahren nach Anspruch 10, wobei die magnetischen Eigenschaften des Teils, seine elektrischen Eigenschaften oder eine Kombination aus diesen mechanisch verändert werden.

12. Verfahren nach Anspruch 10 oder 11, wobei das Teil in mindestens einer Dimension gestreckt oder komprimiert ist.

13. Verfahren nach einem der Ansprüche 10 bis 11, wobei die Maße des Teils in mindestens einer Dimension um 0,01 bis 20 %, insbesondere um ca. 0,1 bis 15 %, verändert werden.

14. Verfahren nach einem der Ansprüche 9 bis 13, wobei die Veränderung der elektromagnetischen Eigenschaften des Teils mittels eines Sensors festgestellt wird.

## Revendications

1. Procédé pour déterminer la compatibilité mutuelle de deux éléments à relier, dans lequel
- le premier élément est équipé d'une pièce de marquage de sécurité tridimensionnel qui consiste en une pièce d'alliage métallique qui peut changer sa forme ou ses propriétés magnétiques à cause de l'effet d'un champ magnétique, de la chaleur, d'un rayonnement thermique, d'une force mécanique ou d'une combinaison de ceux-ci,
- le deuxième élément est relié au premier élément au moyen d'un dispositif de fonctionnement qui peut produire un champ magnétique, de la chaleur, un effet de rayonnement thermique, une force mécanique ou une combinaison de ceux-ci,
- le premier et le deuxième élément sont mis à proximité immédiate l'un de l'autre,
- le dispositif de fonctionnement du deuxième élément est utilisé pour diriger un champ magnétique, la chaleur, un effet de rayonnement thermique, une force mécanique ou une combinaison de ceux-ci à la pièce d'alliage métallique pour changer la forme tridimensionnelle ou les propriétés magnétiques de la pièce de marquage de sécurité,
- le changement de la forme ou des propriétés de la pièce de marquage de sécurité est déterminé, et
- les éléments sont déterminés compatibles si le changement de la forme ou des propriétés magnétiques excède une valeur limite prédéfinie,
dans lequel la liaison entre le premier et le deuxième élément n'est possible que si la pièce de marquage de sécurité est dans un état de déformation, ou si un élément est une machine ou un dispositif et l'autre élément est une pièce remplaçable de la machine ou du dispositif,
et dans lequel l'alliage métallique consiste en un alliage NiMnGa qui possiblement comprend un métal additionnel ou plus métaux additionnels tels que Co, Fe, Cu, In ou Sn.

2. Procédé selon la revendication 1, dans lequel le changement de la forme de la pièce reliée au premier élément est déterminé mécaniquement, électriquement, magnétiquement ou par une combinaison de ceux-ci, notamment mécaniquement et électriquement.

3. Procédé selon la revendication 1 ou 2, dans lequel la pièce de marquage de sécurité reliée au premier élément est disposée de manière que la pièce, dans l'état dans lequel sa forme a été changée par l'effet de tension, d'un champ électrique ou magnétique, de la chaleur, de rayonnement thermique ou d'une combinaison de ceux-ci, crée un fonctionnement ou une fonction.

4. Procédé selon la revendication 3, dans lequel la pièce de marquage de sécurité déclenche un fonctionnement ou une fonction lorsqu'elle change à un état de déformation.

5. Procédé selon l'une quelconque des revendications précédentes, dans lequel le changement de la forme de la pièce de marquage de sécurité est détecté au moyen d'un capteur.

6. Procédé selon la revendication 1, dans lequel la pièce de marquage de sécurité et l'élément de fonctionnement forment ensemble un blocage, ou font partie d'un circuit électrique, ou peuvent créer sa liaison de sorte que la pièce de marquage de sécurité puisse débloquer le blocage ou relier le circuit électrique de sorte que le dispositif crée le fonctionnement sélecté ou les fonctionnements sélectés après le déblocage.

7. Procédé selon la revendication 1, dans lequel les éléments forment ensemble une structure de dispositif qui a un fonctionnement présélectionné ou une fonction présélectionnée, auquel cas la pièce de marquage de sécurité tridimensionnelle est disposée de manière que la pièce de marquage de sécurité, dans un état dans lequel la forme de ladite pièce de sécurité tridimensionnelle a changé à la suite de l'effet de la tension, d'un champ électrique ou magnétique, de la chaleur, de rayonnement thermique, d'une force mécanique, ou d'une combinaison de ceux-ci, permet ledit fonctionnement ou ladite fonction.

8. Procédé selon l'une quelconque des revendications précédentes, dans lequel
- la pièce de marquage de sécurité consiste en un alliage métallique et
- la pièce d'alliage métallique est fabriquée d'un matériau en métal à mémoire de forme (AMF) qui change sa forme à cause de l'effet de changements de température, d'un matériau magnétostrictif, d'un matériau en métal à mémoire de forme magnétique ou d'un polymère électroactif (muscles artificiels).

9. Procédé selon l'une quelconque des revendications précédentes, dans lequel la pièce de marquage de sécurité consiste en un matériau au monocristallin, un matériau au poylcristallin, ou un matériau composite auquel cas la substance comprend, par exemple, des granulés et un liant, ou un matériau en couche mince.

10. Procédé selon l'une quelconque des revendications précédentes, dans lequel
- le premier élément est équipé d'une pièce d'alliage métallique tridimensionnelle dont les propriétés électromagnétiques changent en fonction des dimensions de la pièce,
- l'effet mécanique est dirigé par le deuxième élément à la pièce d'alliage métallique du premier élément pour changer les dimensions de la pièce d'alliage métallique pour modifier les propriétés électromagnétiques de ladite pièce d'alliage métallique,
- les propriétés électromagnétiques de la pièce d'alliage métallique sont déterminées, et
- les éléments sont déterminés compatibles si le changement des propriétés électromagnétiques excède une valeur limite prédéfinie.

11. Procédé selon la revendication 10, dans lequel les propriétés magnétiques de la pièce, ses propriétés électriques ou une combinaison de celles-ci sont changées mécaniquement.

12. Procédé selon la revendication 10 ou 11, dans lequel la pièce est étirée ou comprimée dans au moins une dimension.

13. Procédé selon l'une quelconque des revendications 10 à 12, dans lequel les dimensions de la pièce sont changées par 0,01 à 20 %, notamment par environ 0,1 à 15 %, dans au moins une dimension.

14. Procédé selon l'une quelconque des revendications 9 à 13, dans lequel le changement des propriétés électromagnétiques de la pièce est déterminé au moyen d'un capteur.
